# EUROPEAN PATENT APPLICATION

(11) **EP 4 604 167 A1**
(43) Date of publication of application: **20.08.2025**
(21) Application number: 23876271.0
(22) Date of filing: 03.07.2023
(51) Int. Cl.: H01J 37/32

(54) **PLASMA ETCHING APPARATUS, DIELECTRIC WINDOW HEATING DEVICE AND SYSTEM**

(30) Priority: 14.10.2022 CN 202211260536
(71) Applicant: Jiangsu Leuven Instruments Co., Ltd., Xuzhou, Jiangsu 221300 (CN)
(72) Inventor: CHEN, Shuai, Xuzhou, Jiangsu 221300 (CN); LIU, Haiyang, Xuzhou, Jiangsu 221300 (CN); LIU, Xiaobo, Xuzhou, Jiangsu 221300 (CN); LI, Hao, Xuzhou, Jiangsu 221300 (CN); LI, Baishun, Xuzhou, Jiangsu 221300 (CN); HU, Dongdong, Xuzhou, Jiangsu 221300 (CN); XU, Kaidong, Xuzhou, Jiangsu 221300 (CN)
(74) Representative: Eisenführ Speiser
(86) International application number: PCT/CN2023/105501
(87) International publication number: WO 2024/078063

(57) **Abstract**

A plasma etching apparatus, a dielectric window heating device and a system. In the present invention, a heating element is wrapped by a heat conductor; on one hand, the heat of the heating element can be directly transferred to a dielectric window via a lower heat conductor in direct contact with the dielectric window; and on the other hand, part of the heat of the heating element is dissipated via an upper heat conductor located on a side facing away from the dielectric window. Thus, the heat of the heating element can be rapidly dissipated via the heat conductor, thus avoiding the accumulation phenomenon.

## Description

The present application claims the priority to Chinese Patent Application No. 202211260536.8, titled "PLASMA ETCHING APPARATUS, DIELECTRIC WINDOW HEATING DEVICE AND SYSTEM", filed on October 14, 2022 with the China National Intellectual Property Administration, which is incorporated herein by reference in its entirety.

### FIELD

The present application relates to the technical field of semiconductors, and in particular to a plasma etching apparatus, a dielectric window heating device and a dielectric window heating system.

### BACKGROUND

The inductively coupled plasma etching works on the principle that, under vacuum conditions, radio frequency power generated by an upper radio frequency power supply is outputted to a coil, coupling with a certain proportion of mixed gases to produce a glow discharge. The generated high-density plasma bombards a surface of a substrate surface under the action of a lower radio frequency, breaking the semiconductor chemical bonds on the bombarded surface. The resulting particles are combined with the etching gases to form volatile substances, which are then pumped away through a vacuum pipeline, thereby achieving the purpose of etching a wafer.

The coupling coil is located outside the vacuum environment above a dielectric window of a chamber, and the dielectric window serves to seal the vacuum environment. During the etching process, etching products may deposit on the ceramic dielectric window and cannot be pumped away by the vacuum pump, or the uneven deposition on the surface of the dielectric window may cause the contamination to be peeled off, which further affects particle performance.

Therefore, a dielectric window heating device is crucial for reducing such deposition. The current dielectric window heating device employs a thermal conductive structure that is in contact with a heating element, and the entire thermal conductive structure is wrapped in a thermal and electrical insulation material, which prevents the thermal conductive structure from directly contacting the surface of the dielectric window. Due to the thermal and electrical insulation layer wrapped on the thermal conductive structure connected to the heating element, the heat dissipation performance is poor, which is not conducive to controlling the temperature uniformity of the dielectric window and may affect the etching particle performance.

Therefore, how to address the aforementioned defect is a technical problem of concern to those skilled in the art.

### SUMMARY

An object of the present application is to provide a dielectric window heating device, a dielectric window heating system, and a plasma etching apparatus, which have more uniform temperature distribution across the dielectric window.

A dielectric window heating device is provided according to the present application, including a heating element and a thermal conductor. The heating element is enclosed in the thermal conductor, and is electrically insulated from and in thermal conduction with the thermal conductor. A side surface of the thermal conductor is configured to be in contact with a dielectric window, and another side surface of the thermal conductor is configured to be exposed in a reaction chamber of a plasma etching apparatus.

In the present application, the heating element is enclosed in the thermal conductor. On the one hand, the heat can be directly transferred from the heating element to the dielectric window through a lower layer of the thermal conductor that is in direct contact with the dielectric window. On the other hand, some of the heat of the heating element is dissipated through an upper layer of the thermal conductor located on a side away from the dielectric window. This allows the heat of the heating element to be quickly dissipated through the thermal conductor, preventing any accumulation of heat.

In an embodiment, the thermal conductor includes an upper thermally conductive housing and a lower thermally conductive housing, which enclose to form a mounting space for the heating element.

In an embodiment, the thermal conductor includes an annular body and radial bodies extending inward from an inner side of the annular body. Each two adjacent radial bodies are spaced apart from each other, and a width of each of the radial bodies decreases in a direction towards a center of the dielectric window. The heating element is provided in each of the radial bodies and the annular body.

In an embodiment, the radial bodies include two types of radial bodies with different radial lengths, and the two types of radial bodies are arranged alternately along a circumferential direction.

In an embodiment, the number of the dielectric window heating device is at least two, and the at least two dielectric window heating devices are arranged on an upper surface of the dielectric window.

In an embodiment, the dielectric window heating device includes a first heating device and a second heating device, which are symmetrically arranged about the center of the dielectric window.

In an embodiment, each of the first heating device and the second heating device is provided with a heating body arranged in a Faraday configuration.

In an embodiment, the heating element includes a resistance wire or an electric heating tube.

In an embodiment, the thermal conductor is made of metal material.

In an embodiment, the thermal conductor is made of non-metal material.

In an embodiment, the non-metal material includes silica gel.

In addition, a dielectric window heating system for a plasma etching apparatus is provided according to the present application, including the following components:
the dielectric window heating device according to any one of the above solutions, where the side surface of the thermal conductor is in contact with a dielectric window, and the another side surface is exposed in a reaction chamber of the plasma etching apparatus; and
a first heat dissipation fan, which is located at a side of the dielectric window heating device away from the dielectric window and faces a central area of the dielectric window.

The dielectric window heating system according to the present application is provided with the dielectric window heating device and the first heat dissipation fan. On the one hand, the heat of the heating element can be directly transferred to the dielectric window through the lower layer of the thermal conductor that is in direct contact with the dielectric window. On the other hand, some of the heat of the heating element, after being dissipated through the upper layer of the thermal conductor located on the side away from the dielectric window, may be blown towards the dielectric window by the first heat dissipation fan. Additionally, under the action of the first heat dissipation fan, central and edge temperatures of the dielectric window may converge, thereby reducing the etching deposition.

In an embodiment, the dielectric window heating system further includes a second heat dissipation fan, which is located at the same side as the first heat dissipation fan. A distance from the second heat dissipation fan to a central axis of the reaction chamber of the plasma etching apparatus is greater than a distance from the first heat dissipation fan to the central axis, and the second heat dissipation fan is located within a projection of the dielectric window perpendicular to an axial direction.

In an embodiment, the number of the second heat dissipation fan is at least two, and the at least two second heat dissipation fans are uniformly arranged around and centered on the first heat dissipation fan.

In an embodiment, the second heat dissipation fan is located at a periphery of the first heat dissipation fan, and a projection of the second heat dissipation fan on the dielectric window does not overlap with a projection of the first heat dissipation fan on the dielectric window.

In an embodiment, a center of a wind outlet of the first heat dissipation fan, a center of the heating device, and a center of the dielectric window are coaxial.

In an embodiment, the first heat dissipation fan and the second heat dissipation fan are mounted at a top of an inner wall of the reaction chamber.

In an embodiment, the thermal conductor is adhesively fixed to the dielectric window.

In an embodiment, the dielectric window heating system further includes a temperature measurer, which is configured to at least obtain temperatures at two different radial positions on the dielectric window. Power of the first heat dissipation fan and power of the second heat dissipation fan are adjustable based on the temperatures at the two different radial positions obtained by the temperature measurer to regulate wind speeds of the two fans, so that the temperatures measured by the temperature measurer are within a preset temperature range.

In addition, a plasma etching apparatus is further provided according to the present application, including the dielectric window heating system according to any one of the above solutions.

The dielectric window heating system and the plasma etching apparatus according to the present application include the aforementioned dielectric window heating device, and therefore also have the aforementioned technical effects of the dielectric window heating device.

### BRIEF DESCRIPTION OF THE DRAWINGS

FIG. 1 is a schematic view of a dielectric window heating system according to a specific embodiment of the present application;
FIG. 2 is a schematic view showing only a part of a dielectric window heating device and a dielectric window in FIG. 1;
FIG. 3 is a schematic top view showing the structure of the dielectric window heating device and the dielectric window in FIG. 1;
FIG. 4 is a graph showing temperature distribution curves of dielectric windows according to the present application and the conventional technology respectively; and
FIG. 5 is a graph showing changes in temperature at a central area and an edge area of the dielectric window with respect to a wind speed of a first heat dissipation fan.

### DETAILED DESCRIPTION OF THE EMBODIMENTS

In the description of the embodiments of the present application, the directional terms such as "inner" and "outer" only refer to directions in the drawings. Therefore, these terms are only used for illustrating and understanding the embodiments of the present application more clearly, rather than indicating or implying that the device or element referred to must have a specific orientation or can only be configured and operated in a particular orientation. Therefore, these terms should not be construed as limitations to the embodiments of the present application. In addition, in the description of the present application, unless otherwise specified, the term "multiple" means two or more.

In order to provide those skilled in the art a better understanding of the technical solutions of the present application, the present application is described hereinafter in further detail in conjunction with the drawings and specific embodiments.

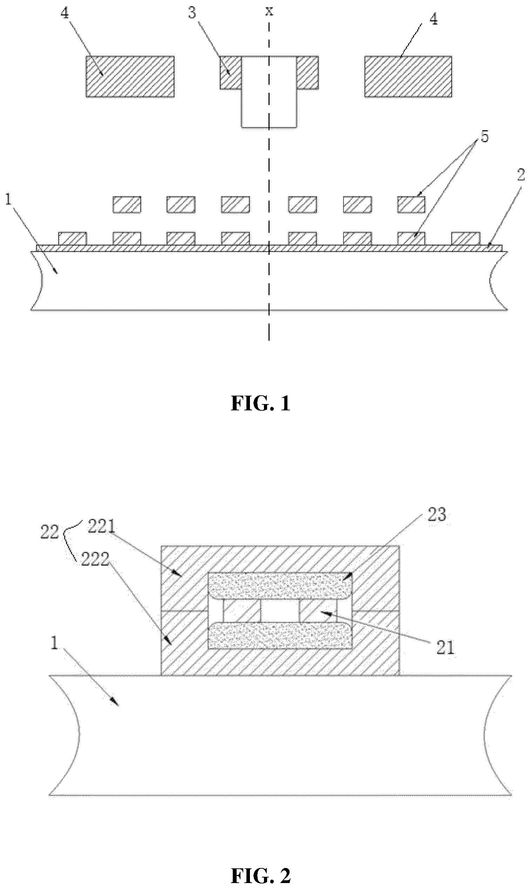

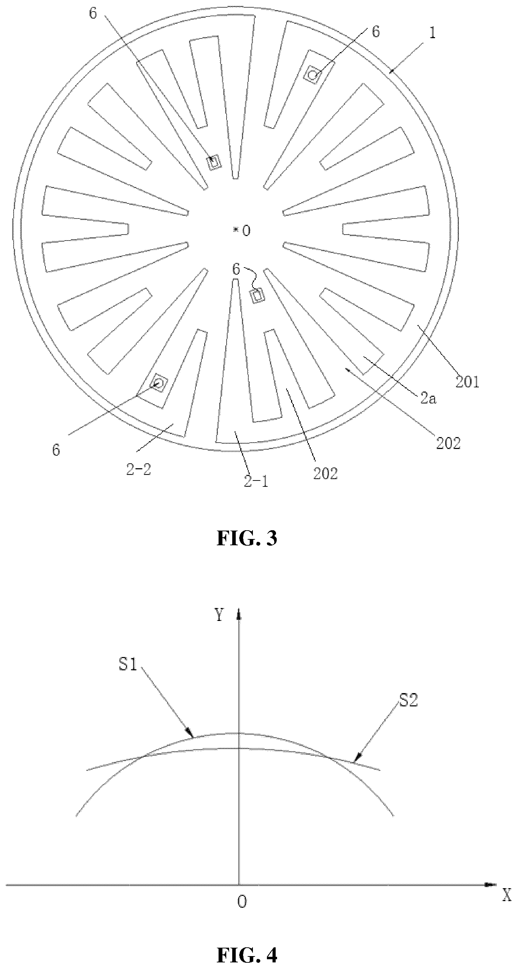

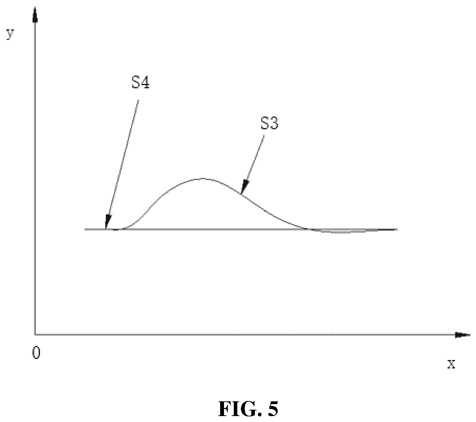

References are made to FIGS. 1 to 5. FIG. 1 is a schematic view of a dielectric window heating system according to a specific embodiment of the present application. FIG. 2 is a schematic view showing only a part of a dielectric window heating device and a dielectric window in FIG. 1. FIG. 3 is a schematic top view showing the structure of the dielectric window heating device and the dielectric window in FIG. 1. FIG. 4 is a graph showing temperature distribution curves of dielectric windows according to the present application and the conventional technology respectively. FIG. 5 is a graph showing changes in temperature at a central area and an edge area of the dielectric window with respect to a wind speed of a first heat dissipation fan.

A dielectric window heating system for a plasma etching apparatus is provided according to the present application. The dielectric window heating system of the present application includes a dielectric window 1, a dielectric window heating device 2, and a first heat dissipation fan 3. The plasma etching apparatus includes a reaction chamber, and the dielectric window 1, the dielectric window heating device 2, and the first heat dissipation fan 3 of the dielectric window heating system are disposed inside the reaction chamber.

The dielectric window heating device 2 according to the present application includes a heating element 21 and a thermal conductor 22. The heating element 21 is enclosed in the thermal conductor 22 and is electrically insulated from and in thermal conduction with the thermal conductor 22. The heating element 21 may be an element, such as a resistance wire or an electric heating tube, which can generate heat when connected to and powered by a power source. The thermal conductor 22 may be made of metal with good thermal conductivity, such as copper or aluminum. Alternatively, the thermal conductor 22 may be made of non-metal with good thermal conductivity, such as silica gel.

In the present application, the thermal conductor 22 wrapped around the heating element 21 is in contact with the dielectric window 1. The thermal conductor 22 is fully in contact with the dielectric window 1. This allows the heat generated by the heating element 21 to be quickly transferred to the dielectric window 1 through the thermal conductor 22. A shape of a surface of the thermal conductor 22 facing the dielectric window 1 may be determined based on a shape of an upper surface of the dielectric window 1 cooperating with the surface of thermal conductor 22. Typically, the upper surface of the dielectric window 1 is flat, and the surface of the thermal conductor 22 facing the dielectric window 1 is also flat to facilitate the surface-to-surface contact between the two components. Another surface of the thermal conductor 22 away from the dielectric window 1 is exposed in the reaction chamber. That is, a side surface of the thermal conductor 22 according to the present application is in full contact with the dielectric window 1, while another side surface of the thermal conductor 22 is exposed in the reaction chamber.

The first heat dissipation fan 3 according to the present application is located at a side of the dielectric window heating device away from the dielectric window 1 and faces a central area of the dielectric window. It should be clarified that the central area of the dielectric window referred to herein may be a center of the dielectric window 1, or a circular area that is centered on the dielectric window 1 and has a predetermined radius. It can be understood that the central area of the dielectric window is an area on the dielectric window 1 close to its center.

In the present application, the heating element 21 is wrapped in the thermal conductor 22. On the one hand, the heat of the heating element 21 can be directly transferred to the dielectric window 1 through a lower layer of the thermal conductor 22 that is in direct contact with the dielectric window 1. On the other hand, some of the heat of the heating element 21 is dissipated through an upper layer of the thermal conductor 22 on the side away from the dielectric window 1 and is blown towards the dielectric window 1 under the action of the first heat dissipation fan 3. This allows the heat of the heating element 21 to be quickly dissipated through the thermal conductor 22 without accumulating, and under the action of the first heat dissipation fan 3, central and edge temperatures of the dielectric window 1 tend to be consistent, thereby reducing etching deposition.

Referring to FIG. 5, the horizontal axis represents a wind speed of the first heat dissipation fan 3, and the vertical axis represents a temperature. The curve S3 shows the variation of the temperature at the central area of the dielectric window with respect to the wind speed of the first heat dissipation fan 3, and the curve S4 shows the variation of the temperature at an edge area of the dielectric window 1 with respect to the wind speed of the first heat dissipation fan 3. As can be seen from the graph, the temperature at the central area of the dielectric window is significantly affected by the wind speed of the first heat dissipation fan 3, while the temperature at the edge area of the dielectric window 1 is less affected by the wind speed of the first heat dissipation fan 3. By controlling the wind speed of the first heat dissipation fan 3, the temperatures at the central and edge areas of the dielectric window can converge to a same value.

With further reference to FIG. 4, FIG. 4 shows radial temperature distribution curves of a dielectric window 1 according to the conventional technology and the dielectric window 1 according to the technical solution of the present application respectively, where S2 is the radial temperature distribution curve of the dielectric window 1 according to the present application, and S1 is the radial temperature distribution curve of a dielectric window according to the conventional technology. The horizontal axis represents a distance to the center O of the dielectric window, and the vertical axis represents the temperature value. As can be seen from the graph, for S1, the temperature is high at the center of the dielectric window, and decreases with the increase of the distance to the center O of the dielectric window, exhibiting a significant difference between the edge temperature and the central temperature. The S2 curve changes more gently with a smaller temperature difference between points on the curve, that is, the temperature of the dielectric window 1 basically remains constant in a longitudinal direction.

The dielectric window heating system according to the present application further includes a second heat dissipation fan 4, which is arranged at the same side as the first heat dissipation fan 3. Both the second heat dissipation fan 4 and the first heat dissipation fan 3 can be mounted on a top wall of the reaction chamber. A distance between the second heat dissipation fan 4 and a central axis of the reaction chamber of the plasma etching apparatus is greater than a distance between the first heat dissipation fan 3 and the central axis. The second heat dissipation fan 4 may be arranged at a predetermined distance from the central axis of the reaction chamber and is located within a projection of the dielectric window 1 perpendicular to an axial direction, that is, the second heat dissipation fan 4 is located in a peripheral area of the first heat dissipation fan 3.

In addition to the dielectric window 1 and the dielectric window heating device 2, a coil 5 is further provided inside the reaction chamber, which also generates heat during operation. The first heat dissipation fan 3 and the second heat dissipation fan 4 jointly dissipate heat from the coil 5, the dielectric window 1, and the dielectric window heating device 2, achieving higher heat dissipation efficiency and more uniform heat distribution across the dielectric window 1.

According to the aforementioned embodiment, the number of the second heat dissipation fans 4 is at least two, and the second heat dissipation fans 4 are evenly arranged around and centered on the first heat dissipation fan 3.

Ideally, a center of a wind outlet of the first heat dissipation fan 3, a center of the dielectric window heating device 2, and the center of the dielectric window 1 are coaxial. Considering actual assembly and manufacturing errors, however, a predetermined deviation among the centers of these three components is tolerable.

According to the above embodiments, the dielectric window heating system further includes a temperature measurer 6, which can at least obtain temperatures at two different radial positions on the dielectric window 1. That is, the temperature measurer 6 can measure the temperatures at two or more positions which are at different distances from the center of the dielectric window. FIG. 3 shows that the temperature measurers 6 are provided at four positions on the dielectric window 1 respectively. Apparently, the more temperature measurers 6 there are, the more precise the temperature measurement will be at various positions on the dielectric window 1, but this may complicate subsequent control. In practice, the positions of the temperature measurer 6 may be reasonably determined to balance both aspects.

In this embodiment, power of the first heat dissipation fan 3 and power of the second heat dissipation fan 4 are adjustable based on the temperatures at the two different radial positions obtained by the temperature measurer 6 to regulate their wind speeds, so that the temperatures measured by the temperature measurer 6 are within a preset temperature range. That is, the wind speeds of the first heat dissipation fan 3 and the second heat dissipation fan 4 may be determined based on the temperatures measured by the temperature measurer 6. By controlling their wind speeds, the temperature measured by each temperature measurer 6 can be maintained within the predetermined temperature range, thereby achieving uniform temperature control across the dielectric window 1. This is particularly crucial to overall temperature control of the dielectric window 1 at high power, and can effectively reduce the etching deposition.

The temperature measurer 6 may be a temperature sensor.

Further, to facilitate the mounting of the heating element 21, the thermal conductor 22 includes an upper thermally conductive housing 221 and a lower thermally conductive housing 222, which enclose to form a mounting space for the heating element 21. A side surface of the lower thermally conductive housing is in contact with the dielectric window 1, and an upper side surface of the upper thermally conductive housing 221 is exposed in the reaction chamber. The upper thermally conductive housing 221 and the lower thermally conductive housing 222 are in direct contact and thermal conduction with each other.

Electrical insulation between the heating element 21 and the thermal conductor 22 can be achieved by providing an insulating layer on a surface of the heating element 21 or by providing an insulating material 23 between the heating element 21 and the thermal conductor 22. As shown in FIG. 2, the insulating material 23 is provided between the heating element 21 and each of the upper thermally conductive housing 221 and the lower thermally conductive housing 222. The insulating material may be plastic or other materials with insulating properties in the conventional technology.

It has been found in the present application that heat accumulation on the dielectric window 1 primarily occurs near the central area. To further avoid the heat accumulation, the following arrangements are further provided according to the present application.

In a specific example, the thermal conductor 22 includes an annular body 201 and radial bodies 202 extending inward from an inner side of the annular body 201. Each two adjacent radial bodies 202 are spaced apart by a distance 2a, and a width of each of the radial bodies 202 decreases in a direction towards the center of the dielectric window 1. The heating element 21 is provided inside each of the radial bodies 202 and the annular body 201. The heating element 21 disposed inside the annular body 201 and the radial bodies 202 may be continuous. The gaps between the radial bodies 202 facilitate smooth plasma passage. In the present application, each radial body 202 has a width (the area of a part of the dielectric window 1 it covers) increasing towards the edge, forming a petal-like shape. An area of the radial bodies 202 corresponding to the central area of the dielectric window is relatively small, while an area of the radial bodies 202 corresponding to the edge area outside the central area of the dielectric window is relatively large. This balances the heat between the central and edge areas, allowing them to heat up more synchronously.

Apparently, the radial bodies 202 may be identical or different. FIG. 4 shows a configuration of two types of radial bodies 202 with different radial lengths but the same shape variation trend, and these two types of radial bodies 202 are arranged alternately.

Certainly, the shapes of the radial bodies 202 are not limited to the arc-shaped structure disclosed in the present application and can be other forms.

There may be one dielectric window heating device, or there may be multiple dielectric window heating devices. The figure shows a specific embodiment where the dielectric window 1 is provided with a first heating device 2-1 and a second heating device 2-2, which are roughly symmetrically arranged. The first heating device 2-1 and the second heating device 2-2 each has a heating body in a Faraday configuration.

Certainly, the number of the dielectric window heating devices is not limited to two, as mentioned herein, and may be more. The multiple dielectric window heating devices are arranged on the upper surface of the dielectric window 1.

Based on the dielectric window heating system, a plasma etching apparatus is further provided according to the present application, including the dielectric window heating system according to any one of the above embodiments.

Other structures of the plasma etching apparatus according to the present application may refer to the conventional technology, which will not be described in detail herein.

The plasma etching apparatus according to the present application includes the dielectric window heating system and therefore has the technical effects of the dielectric window heating system.

The plasma etching apparatus and the dielectric window heating system according to the present application are described in detail above. The principle and implementation of the present application are illustrated using specific embodiments herein. The above description of the embodiments is only for facilitating the understanding of the method and the core idea of the present application. It should be noted that, several improvements and modifications may be made to the present application by those skilled in the art without departing from the principle of the present application, and these improvements and modifications also fall within the protection scope of the claims of the present application.

## Claims

1. A dielectric window heating device, comprising:
a heating element; and
a thermal conductor, wherein
the heating element is enclosed in the thermal conductor, and is electrically insulated from and in thermal conduction with the thermal conductor; and
a side surface of the thermal conductor is configured to be in contact with the dielectric window, and another side surface of the thermal conductor is configured to be exposed in a reaction chamber of a plasma etching apparatus.

2. The dielectric window heating device according to claim 1, wherein the thermal conductor comprises an upper thermally conductive housing and a lower thermally conductive housing, which enclose to form a mounting space for the heating element.

3. The dielectric window heating device according to claim 1 or 2, wherein the thermal conductor comprises an annular body and radial bodies extending inward from an inner side of the annular body, each two adjacent radial bodies are spaced apart from each other, a width of each of the radial bodies decreases in a direction towards a center of the dielectric window, and the heating element is provided in each of the radial bodies and the annular body.

4. The dielectric window heating device according to claim 3, wherein the radial bodies include two types of radial bodies with different radial lengths, and the two types of radial bodies are arranged alternately along a circumferential direction.

5. The dielectric window heating device according to claim 3, wherein the number of the dielectric window heating device is at least two, and the at least two dielectric window heating devices are arranged on an upper surface of the dielectric window.

6. The dielectric window heating device according to claim 3, wherein the dielectric window heating device comprises a first heating device and a second heating device, which are symmetrically arranged about the center of the dielectric window.

7. The dielectric window heating device according to claim 6, wherein each of the first heating device and the second heating device is provided with a heating body arranged in a Faraday configuration.

8. The dielectric window heating device according to claim 1 or 2, wherein the heating element comprises a resistance wire or an electric heating tube.

9. The dielectric window heating device according to claim 1 or 2, wherein the thermal conductor is made of metal material.

10. The dielectric window heating device according to claim 1 or 2, wherein the thermal conductor is made of non-metal material.

11. The dielectric window heating device according to claim 10, wherein the non-metal material comprises silica gel.

12. A dielectric window heating system for a plasma etching apparatus, comprising:
the dielectric window heating device according to any one of claims 1 to 11, wherein the side surface of the thermal conductor is in contact with a dielectric window, and the another side surface of the thermal conductor is exposed in a reaction chamber of the plasma etching apparatus; and
a first heat dissipation fan, which is located at a side of the dielectric window heating device away from the dielectric window and faces a central area of the dielectric window.

13. The dielectric window heating system according to claim 12, further comprising a second heat dissipation fan, which is located at the same side as the first heat dissipation fan, wherein a distance from the second heat dissipation fan to a central axis of the reaction chamber of the plasma etching apparatus is greater than a distance from the first heat dissipation fan to the central axis, and the second heat dissipation fan is located within a projection of the dielectric window perpendicular to an axial direction.

14. The dielectric window heating system according to claim 13, wherein the second heat dissipation fan is located at a periphery of the first heat dissipation fan, and a projection of the second heat dissipation fan on the dielectric window does not overlap with a projection of the first heat dissipation fan on the dielectric window.

15. The dielectric window heating system according to claim 13, wherein the number of the second heat dissipation fan is at least two, and the at least two second heat dissipation fans are uniformly arranged around and centered on the first heat dissipation fan.

16. The dielectric window heating system according to claim 13, wherein a center of a wind outlet of the first heat dissipation fan, a center of the heating device, and a center of the dielectric window are coaxial.

17. The dielectric window heating system according to claim 13, wherein the first heat dissipation fan and the second heat dissipation fan are mounted at a top of an inner wall of the reaction chamber.

18. The dielectric window heating system according to claim 13, wherein the thermal conductor is adhesively fixed to the dielectric window.

19. The dielectric window heating system according to any one of claims 13 to 18, further comprising a temperature measurer, which is configured to at least obtain temperatures at two different radial positions on the dielectric window, wherein power of the first heat dissipation fan and power of the second heat dissipation fan are adjustable based on the temperatures at the two different radial positions obtained by the temperature measurer to regulate wind speeds of the two fans, so that the temperatures measured by the temperature measurer are within a preset temperature range.

20. A plasma etching apparatus, comprising the dielectric window heating system according to any one of claims 12 to 19.
